Europäisches Patentamt

European Patent Office

Office européen des brevets

(19)

(11) EP 0 453 693 B1

(12) **FASCICULE DE BREVET EUROPEEN**

| | |
|---|---|
| (45) Date de publication et mention de la délivrance du brevet: **28.05.1997 Bulletin 1997/22** | (51) Int Cl.[6]: **G01R 1/067**, G01R 15/00, G01R 29/08, G01R 29/12, G02F 1/03 |

(21) Numéro de dépôt: **90403751.2**

(22) Date de dépôt: **21.12.1990**

(54) **Capteur de champ électrique à effet pockels**

Pockelseffekt-Messsonde für elektrische Felder

Electric field pockels effect sensor

(84) Etats contractants désignés:
**DE GB IT NL SE**

(30) Priorité: **26.12.1989 FR 8917179**
**12.04.1990 FR 9004731**

(43) Date de publication de la demande:
**30.10.1991 Bulletin 1991/44**

(73) Titulaire: **COMMISSARIAT A L'ENERGIE ATOMIQUE**
**75015 Paris (FR)**

(72) Inventeur: **Chollet, Pierre-Alain**
**F-92140 Clamart (FR)**

(74) Mandataire: **Poulin, Gérard et al**
**Société BREVATOME**
**25, rue de Ponthieu**
**75008 Paris (FR)**

(56) Documents cités:
**DE-A- 3 729 382** **FR-A- 2 595 820**

- **DIGEST OF TECHNICAL PAPERS, 7TH IEEE PULSED POWER CONFERENCE, Monterey, CA, 11th - 14th June 1989, pages 380-383, New York, US; M.C. McKINLEY et al.: "A spherical electro-optic high-voltage sensor"**
- **REVIEW OF SCIENTIC INSTRUMENTS, vol. 60, no. 7, partie 1, juillet 1989, pages 1251-1257; K. HIDAKA et al.: "Simultaneous measurement of two orthogonal components of electric field using a Pockels device"**
- **PROCEEDINGS OF THE FIRST INTERNATIONAL CONFERENCE ON OPTICAL FIBRE SENSORS, 26- 28 avril 1983, pages 164-168, IEE, Londres, GB; K. SHIBATA: "A fibre optic electric field sensor using the electrooptic effect of Bi4Ge3012"**
- **PATENT ABSTRACTS OF JAPAN, vol. 8, no. 121 (P-278)[1558], 7 juin 1984; & JP-A-59 27 266**
- **PATENT ABSTRACTS OF JAPAN, vol. 7, no. 10 (P-168)[1155], 14 janvier 1983; & JP-A-57 168 167**

## Description

La présente invention a pour objet un capteur de champ électrique à effet Pockels comportant comme élément sensible un corps cristallin ayant des propriétés électro-optiques, traversé par un faisceau lumineux incident, de directions de propagation et de polarisation déterminées. Il permet de mesurer non seulement la valeur d'un champ électrique mais aussi sa direction.

Dans la plupart des corps cristallins non centrosymétriques, les indices de réfraction, qui dépendent en général de la direction de propagation et de la polarisation du faisceau incident, varient linéairement avec un champ électrique extérieur appliqué. C'est l'effet Pockels, connu depuis la fin du siècle dernier. Cette variation d'indice peut être mise à profit pour changer la phase du faisceau lumineux ; celle-ci peut alors être mesurée par un système interférométrique comme ceci est effectué dans les modulateurs électro-optiques.

De cette variation de phase on peut en principe remonter à la valeur du champ électrique. En utilisant un cristal isolant et en l'absence de pièce métallique dans le capteur, on peut ainsi mesurer le champ électrique sans trop le perturber. De plus, un tel système présente l'avantage de pouvoir être réalisé avec une source de lumière de faible puissance donc peu coûteuse.

Malheureusement, les phénomènes sont rendus compliqués par le caractère tensoriel de l'effet Pockels. En outre, le tenseur de l'effet Pockels comprend en général 18 coefficients rij non nuls (avec $1 \leq i \leq 6$ et $1 \leq j \leq 3$) et la même variation de phase peut être obtenue pour plusieurs orientations et plusieurs valeurs de champ électrique.

Des capteurs de champ électrique utilisant l'effet Pockels dans des cristaux de faible symétrie ont déjà été réalisés et ont fait l'objet d'une publication de J. Chang et C.N. Vittitoe "An electro-optical technique for measuring high frequency free space electric fields", Fast Electrical and Optical Measurements vol.1, Current and Voltage Measurements Martinus Nijhoff publishers, Dordrecht 1986, édité par J.E. Thompson et L.H. Luessen, pp.57-71 et d'une publication de K.D. Masterson "Photonicelectric-field probe for frequencies up to 2 GHz", SPIE Proceedings, vol. 720 (1986), pp. 100-104.

Ces capteurs ont l'inconvénient de ne permettre que la détermination de la valeur de champs électriques dont on connaît a priori la direction.

Cependant, cet inconvénient disparaît dans les cristaux de haute symétrie pour lesquels de nombreux coefficients du tenseur de Pockels sont identiquement nuls. En particulier, dans le cas de cristaux cubiques, il n'y a plus que trois coefficients qui sont tous égaux. Dans ce cas de symétrie, I.P. Kaminow a montré en 1974 dans "An Introduction to Electrooptic Devices", Academic Press, New-York, pp. 40-51, quelles directions de propagation et de polarisation pouvaient être utilisées pour mesurer le champ électrique dans trois directions perpendiculaires, d'une façon indépendante.

Des capteurs basés sur cette méthode de mesure du champ électrique par effet Pockels dans des cristaux cubiques, ont été décrits dans le document de B.N. Nelson et al. "Fiber optic electric field sensor configurations for high bandwidth lightning research measurement applications", SPIE vol.720 (1986), pp.85-90.

Ces capteurs utilisent des fibres optiques pour guider le faisceau incident entrant dans le cristal et pour guider le faisceau sortant de ce dernier. La polarisation du faisceau incident est réalisée par des polariseurs places juste avant le cristal et l'analyse du faisceau sortant du cristal est réalisée avec un analyseur placé juste après le cristal. Ces polariseurs et analyseurs sont situés dans la sonde de mesure, ce qui a pour inconvénient d'augmenter les dimensions de celle-ci et donc d'empêcher la mesure de champ électrique dans des endroits exigus. En outre, le cristal fonctionne en transmission, ce qui interdit d'effectuer des mesures de champ électrique près d'une paroi.

Par ailleurs, et ce qui est beaucoup plus grave, aucun souci n'a été pris quant à la symétrie géométrique macroscopique du cristal sonde. Or les cristaux électro-optiques utilisés ont une constante diélectrique supérieure à 10 (16 dans le cas du germanate de bismuth $Bi_4Ge_3O_{12}$ ). Aussi, un tel cristal de forme quelconque peut induire des distorsions dans les lignes de champ électrique, ce qui fait que de tels capteurs donnent un bon ordre de grandeur du champ électrique mesuré, mais que la valeur réelle et la direction de ce champ fournies par ces capteurs ne sont nullement garanties. Ces capteurs ne sont donc pas fiables.

En outre, les cristaux sondes utilisés sont taillés en forme de cubes et présentent donc une très forte résonance vibrationnelle dans leur réponse à leur fréquence propre de vibration, valant c/2a où c est la vitesse du son dans le cristal et a le côté du cube. Pour reprendre l'exemple d'une sonde de 1 cm de côté en germanate de bismuth, cette fréquence propre est d'environ 400 kHz et induit d'importantes perturbations dans les études de chocs électriques.

Le problème général et vague de la "distorsion" du champ électrique à mesurer a déjà été posé dans le document de Tanaka JP-A-58 113 764. Pour résoudre ce problème, Tanaka préconise d'utiliser, comme élément sensible à effet Pockels, un composant de forme parallélépipédique comportant sur deux côtés opposés, perpendiculaires au champ électrique à mesurer, des couches diélectriques dont la constante diélectrique a une valeur intermédiaire entre celle de l'élément sensible et celle du milieu ambiant, permettant une variation plus progressive de la constante diélectrique.

Toutefois, de multiples causes de "distorsion" existent et le problème de "distorsion" que cherche en premier à résoudre l'invention est celui de l'écart entre les directions du champ électrique à l'intérieur du cristal et du champ extérieur à mesurer.

L'invention a justement pour objet un capteur de champ électrique à effet Pockels permettant de remédier aux différents inconvénients mentionnés ci-dessus. En particulier, ce capteur permet une mesure précise de la valeur du champ électrique et une détermination précise de l'orientation de ce champ. Par ailleurs, ce capteur peut assurer une mesure de champ électrique auprès d'une paroi et la partie sonde de ce capteur peut être réalisée avec des dimensions plus faibles que celles des sondes de l'art antérieur. En outre, l'influence des fréquences de résonance du cristal est très sensiblement réduite.

De façon plus précise, l'invention a pour objet un capteur de champ électrique à effet Pockels comportant comme élément sensible un cristal à propriétés électro-optiques, traversé par un faisceau lumineux de directions de propagation et de polarisation déterminées, caractérisé en ce que le cristal est taillé sous forme d'un ellipsoïde et présente une symétrie cristallographique soit uniaxiale 622, 422 ou $\overline{4}$2m, soit cubique $\overline{4}$3m ou 23, les trois axes perpendiculaires de l'ellipsoïde étant orientés selon trois axes cristallographiques trirectangles de symétrie la plus élevée du cristal, le cristal possédant en outre au moins un couple de méplats diamétralement opposés et parallèles et disposés à l'endroit où l'un des axes cristallographiques trirectangles émerge du cristal.

Par exemple, dans le cas d'une symétrie 622, les axes de l'ellipsoïde doivent être parallèles à l'axe d'ordre 6 et à un couple d'axes d'ordre 2 perpendiculaires entre eux.

L'utilisation d'un cristal sonde taillé selon l'invention sous forme d'un ellipsoïde et en particulier sous forme d'une sphère permet d'éliminer les distorsions géométriques du champ électrique à mesurer produites par le cristal.

L'originalité de l'invention réside dans la conjonction simultanée des deux propriétés suivantes de la sonde : forme macroscopique, ellipsoïdale et symétrie cristallographique cubique ou uniaxiale particulière du cristal. La première propriété permet d'assurer la constance du champ électrique dans la sonde et de relier d'une façon biunivoque sa valeur avec celle du champ préexistant avant l'introduction de la sonde ; la seconde permet de relier d'une façon biunivoque les effets électro-optiques mesurés au champ régnant dans la sonde.

Les cristaux auxquels s'applique l'invention sont ceux pour Lesquels le tenseur électro-optique (ou de Pockels) n'a que trois coefficients non nuls r41, r52, r63 (le premier indice indique la ligne du tenseur et le second indique la colonne). Pour des cristaux de symétrie cubique $\overline{4}$3m et 23, ces trois coefficients sont égaux alors qu'ils sont différents pour les cristaux de symétrie uniaxiale 622, 422 et $\overline{4}$2m. Ainsi, la réponse optique du capteur pour un cristal à symétrie cubique sera identique pour les trois composantes perpendiculaires du champ électrique alors qu'elle sera différente pour un cristal à symétrie uniaxiale. Dans ce dernier cas, on pourra calculer ces composantes à partir de la connaissance des coefficients r41, r52 et r63 tels que déterminés par des travaux antérieurs ou par un étalonnage préalable dans un champ électrique uniforme de valeur et de direction connues.

Lorsque le monocristal est taillé en forme d'ellipsoïde dont les axes sont parallèles aux axes principaux du tenseur diélectrique (qui constituent un repère dans lequel ce tenseur se diagonalise), il existe une relation simple et biunivoque entre le champ extérieur $\vec{Ee}$ que l'on cherche à mesurer et le champ interne au cristal $\vec{Ei}$. En effet, le tenseur diélectrique se diagonalise dans le repère respectant les plus hautes symétries du cristal.

Ainsi, on peut mesurer précisément la composante du champ électrique dans une direction déterminée par l'utilisateur et cela quelle que soit l'orientation du champ électrique.

Le capteur de l'invention peut donc être un capteur monovoie. Dans le cas d'une sonde ellipsoïdale, la version monovoie ne peut être obtenue que pour certaines orientations des axes de l'ellipsoïde par rapport aux axes cristallographiques, ce qui n'est pas le cas pour un capteur sphérique.

Par ailleurs, il est possible de moduler la réponse dans certaines directions en jouant sur les coefficients de dépolarisation, selon que l'on donne une forme plus ou moins oblongue à l'ellipsoïde.

Le capteur de l'invention comprend avantageusement trois voies optiques de mesure permettant de mesurer indépendamment les trois composantes perpendiculaires du champ électrique. En particulier, les parties des voies de mesure situées dans le cristal sont orientées respectivement selon les trois axes cristallographiques trirectangles de symétrie la plus élevée de ce dernier.

Il utilise le même principe de mesure que celui utilisé dans l'art antérieur. Cette mesure est une mesure purement optique.

Selon un mode particulier de réalisation du capteur de l'invention, chaque voie de mesure comprend une source de lumière monochromatique émettant un faisceau incident, un moyen de polarisation du faisceau incident selon une première direction cristallographique du cristal, des moyens d'introduction du faisceau incident polarise dans le cristal selon une seconde direction cristallographique, un moyen d'analyse du faisceau lumineux sortant du cristal et un élément de détection du signal lumineux analysé. A cet effet, le cristal comporte au moins deux couples de méplats parallèles aux endroits où lesdits axes cristallographiques émergent du cristal.

Au lieu d'utiliser une source de lumière et un détecteur par voie de mesure, il est éventuellement possible d'utiliser une unique source et un unique détecteur pour l'ensemble des voies de mesure. Dans ce cas, un commutateur optique doit être prévu respectivement en sortie de la source lumineuse et en entrée du détecteur.

De façon avantageuse, chaque voie de mesure comprend une fibre optique d'entrée à maintien de polarisation pour le transport du faisceau incident et une fibre optique de sortie à maintien de polarisation pour le transport du faisceau sortant du cristal.

Ce type de fibres permet de placer le moyen de polarisation directement en sortie de la source lumineuse et le moyen d'analyse directement à l'entrée de l'élément de détection. Ceci permet une réduction importante de la partie sonde du capteur par rapport à celle de l'art antérieur, qui est constituée selon l'invention du cristal seul.

L'utilisation de fibres à maintien de polarisation permet d'éloigner les moyens de polarisation et d'analyse du cristal et donc de réduire la perturbation des lignes du champ électrique à mesurer.

De façon à pouvoir effectuer des mesures auprès d'une paroi, le cristal travaille en réflexion. En particulier, pour chaque voie de mesure, le faisceau incident entrant dans le cristal et le faisceau sortant de ce cristal forment un angle de 5° au plus.

L'amplitude de l'onde lumineuse transportée par la fibre optique de sortie varie linéairement avec le champ électrique à mesurer. Il en résulte que l'intensité lumineuse détectée par le détecteur varie quadratiquement avec le champ électrique. Aussi, pour réaliser une détection linéaire, on peut avantageusement interposer une lame quart-d'onde après la fibre d'entrée pour polariser le faisceau lumineux incident circulairement avant son entrée dans le cristal.

Selon un mode de réalisation amélioré du capteur de champ électrique de l'invention, la direction de polarisation du faisceau incident et la direction d'analyse du faisceau sortant du cristal, pour chaque voie de mesure, sont parallèles.

Cette configuration a pour seule conséquence de changer le signe de la réponse en champ électrique fourni par le détecteur, par rapport au cas où les directions de polarisation et d'analyse sont perpendiculaires.

En revanche, cette nouvelle configuration a des conséquences très importantes du point de vue réalisation pratique du capteur, en particulier lorsque ce dernier fonctionne en réflexion.

En particulier, du fait de l'orientation commune des directions de polarisation et d'analyse, il est possible d'assurer ces fonctions de polarisation et d'analyse à l'aide d'un même élément, pour chaque voie de mesure, disposé à l'entrée du cristal. Cet élément de polarisation et d'analyse peut alors être un film polaroïd très mince, donc perturbant très peu le champ électrique. De même, le déphasage introduit entre le faisceau polarisé et le faisceau analysé en vue d'une réponse linéaire du détecteur peut être réalisé, pour chaque voie de mesure, par un double passage dans une lame huitième d'onde disposée en regard de l'élément unique de polarisation et d'analyse.

Ainsi, on peut utiliser la même fibre optique pour chaque voie de mesure, assurant alternativement le transport du faisceau incident et le transport du faisceau sortant du cristal.

Par ailleurs, pour chaque voie de mesure, une seule lentille de focalisation disposée en regard de l'élément de polarisation et d'analyse, d'axe perpendiculaire aux méplats du cristal, peut assurer alternativement la collimation du faisceau incident issu de la fibre puis la focalisation du faisceau sortant du cristal dans cette même fibre.

L'utilisation d'une seule lentille servant respectivement à la collimation du faisceau incident et à la focalisation du faisceau sortant du cristal, au lieu de deux lentilles distinctes de collimation et de focalisation permet une réduction en diamètre des méplats. Ceci permet de conserver le maximum de parties sphériques ou ellipsoïdales, allant ainsi dans le sens du maximum de symétrie.

De plus, la polarisation et l'analyse s'effectuant au voisinage du cristal sonde, on peut utiliser à la place des fibres monomodes à maintien de polarisation, pour chaque voie de mesure, une fibre multimode (par exemple de 125 micromètres de diamètre extérieur avec un coeur de 50 micromètres) pour laquelle les problèmes de couplage sont beaucoup moins critiques (le coeur d'une fibre monomode à maintien de polarisation a des dimensions d'environ 7 micromètres). Cet avantage est indépendant du type de fonctionnement du capteur (transmission ou réflexion), contrairement à l'utilisation d'une même fibre optique, d'une seule lentille, d'une seule lame huitième d'onde et d'un même élément pour la polarisation et l'analyse qui est liée au fait que le cristal travaille en réflexion.

Ainsi, cette configuration du capteur est beaucoup plus simple que celle décrite précédemment.

D'autres caractéristiques et avantages de l'invention ressortiront mieux de la description qui va suivre, donnée à titre illustratif et non limitatif, en référence aux dessins annexés, dans lesquels :

- la figure 1 est un schéma de principe d'un capteur, conforme à l'invention, ne comportant qu'une seule voie de mesure,
- les figures 2a et 2b donnent le principe de fonctionnement d'un capteur conforme à l'invention,
- la figure 3 représente un mode de réalisation d'un capteur selon l'invention à trois voies de mesure, dans lequel le cristal sonde comporte trois couples de méplats,
- la figure 4 représente schématiquement un autre mode de réalisation d'un capteur conforme à l'invention à trois voies de mesure dans lequel le cristal sonde comporte deux couples de méplats,
- la figure 5 complète la figure 4, et
- la figure 6 représente un autre mode de réalisation d'un capteur conforme à l'invention dans lequel les directions de polarisation et d'analyse du faisceau lumineux sont parallèles.

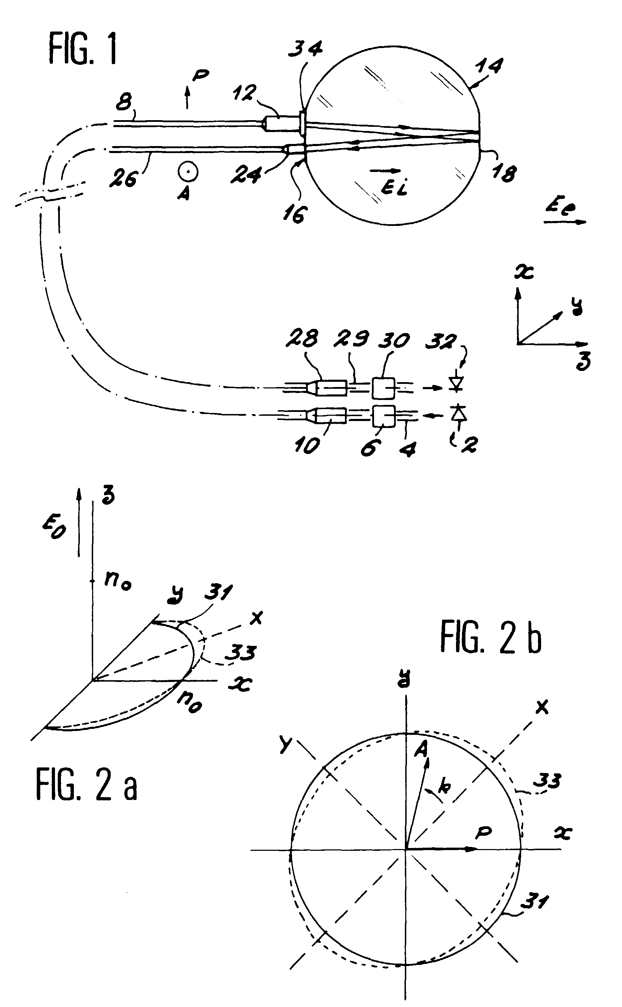

Le schéma de principe du capteur de l'invention représenté sur la figure 1 montre une seule voie de mesure du capteur destinée à mesurer une seule composante d'un champ électrique. Pour un capteur à trois voies de mesure, ces voies sont similaires.

Chaque voie de mesure comporte une source lumineuse 2 constituée par une diode laser monomode émettant un faisceau lumineux monochromatique 4. Ce faisceau 4 est polarise rectilignement selon une première direction x ou y par un polariseur 6 puis focalise dans une fibre d'entrée monomode 8 à maintien de polarisation par une lentille de focalisation 10 du type lentille Selfoc de "pitch" 0,25. L'axe de polarisation de la fibre 8 est orienté selon la première direction.

A la sortie de la fibre optique 8 on trouve une lentille de collimation 12 du type lentille Selfoc de "pitch" 0,25 servant à collimater le faisceau incident polarisé avant son entrée dans le cristal sonde 14 via un premier méplat 16. Le faisceau incident collimaté entrant dans le cristal sonde porte la référence 17.

Selon l'invention, le cristal sonde est un monocristal électro-optique de symétrie uniaxiale 622, 422 ou $\bar{4}$2m, ou de symétrie cubique $\bar{4}$3m (tel que $Bi_4Ge_3O_{12}$) ou 23 taillé sous forme d'ellipsoïde ou de sphère.

Le faisceau incident 17 qui pénètre dans le cristal 14 par le méplat 16 est ensuite réfléchi sur un second méplat 18 du cristal pour ressortir par le méplat 16. Les méplats 16 et 18 sont diamétralement opposés et constituent un couple de méplats. Ils sont polis selon une qualité optique et disposés à l'endroit où l'un des trois axes cristallographiques trirectangles (100), (010) ou (001) du cristal émerge de la sphère 14.

Selon l'invention, l'injection du faisceau incident 17 dans le cristal se fait selon une seconde direction z perpendiculaire à la première direction de polarisation x ou y. En outre, le faisceau incident 17 entrant par le méplat 16 dans le cristal sonde et le faisceau 20 sortant du cristal par ce méplat 16 forment entre eux un angle au plus égal à 5°.

Le faisceau 20 sortant du cristal 14 est focalisé à l'aide d'une lentille de focalisation 24 aussi du type lentille Selfoc de "pitch" 0,25 dans une seconde fibre à maintien de polarisation 26 qui est parallèle à la fibre d'entrée 8 et située du même côté du cristal sonde 14. De plus, l'axe de polarisation de la fibre de sortie est perpendiculaire à celui de la fibre d'entrée 8 et perpendiculaire à la direction de propagation du faisceau lumineux ; si la première direction est la direction x, l'axe de polarisation de la fibre 26 est orienté selon la direction y et si la première direction est la direction y, l'axe de polarisation de la fibre 26 est orienté selon la direction x.

Selon l'invention, les directions x, y et z sont parallèles à trois axes trirectangles de symétrie la plus élevée du cristal.

A la sortie de la fibre 26, on trouve une autre lentille de collimation 28 du type lentille Selfoc. Le faisceau de mesure collimaté 29 est alors reçu par un analyseur 30 croisé à 90° par rapport au polariseur 6, puis détecté par un détecteur 32 du type photodiode.

Pratiquement, les lentilles 10 et 12 sont collées aux deux extrémités de la fibre 8 et les lentilles 24 et 28 sont collées aux deux extrémités de la fibre 26. En outre, les lentilles 12 et 24 sont collées directement sur la sphère 14 en regard du méplat 16.

Le principe de fonctionnement du capteur est la mesure de l'ellipticité induite dans le cristal par le champ électrique à mesurer. Cette mesure est effectuée en comparant la différence de phase entre les polarisations du faisceau incident 17 et du faisceau de mesure 20. Elle n'a de sens que si cette mesure de phase est possible sur toute la section des faisceaux (puisque le détecteur mesure la puissance totale de ces faisceaux). Ceci implique entre autres que le trajet lumineux soit le même pour tous les rayons lumineux, c'est-à-dire que les faisceaux se propagent en onde plane à l'intérieur du cristal. Même si le trajet lumineux est le même pour tous les rayons à l'extérieur du cristal, la condition de propagation en onde plane dans le cristal ne peut être réalisée, compte tenu de la dimension transverse finie des faisceaux, que si le dioptre 16 par lequel pénètre le faisceau incident est plan.

En effet, si la face d'entrée du cristal n'est pas plane, il n'y a aucune raison pour que des rayons lumineux parallèles avant le cristal, sortent parallèles par suite des deux réfractions, à l'entrée et à la sortie du cristal.

Les figures 2a et 2b illustrent le principe de fonctionnement du capteur de l'invention.

Dans un cristal à symétrie cubique soumis à un champ électrique $\vec{Ee}$ parallèle à un axe d'ordre 4 du cristal tel que la direction cristallographique (001) ou direction z (figure 2a), la sphère des indices 31 devient un ellipsoïde 33 dont les axes principaux sont les axes (110), ($\bar{1}$ 10) et (001) notés respectivement X, Y, Z (figure 2b).

La figure 2a montre l'ellipticité créée dans le plan xy en présence d'un champ $\vec{Ee}$ selon z et la figure 2b est une section de l'ellipsoïde des indices 33 dans le plan xy.

Le champ électrique du faisceau polarisé incident reste dans le plan XY et n'est sensible qu'aux variations d'indice induites dans ce plan par le champ continu $\vec{Ei}$ régnant à l'intérieur du cristal, selon les relations $dn_X = r.no^3 .\vec{Ei} /2$ et $dn_Y = -r.no^3 .\vec{Ei}/2$ avec r représentant le coefficient électro-optique (de l'ordre de quelques pm/V) et no est l'indice du cristal en l'absence de champ électrique (c'est-à-dire le rayon de la sphère 31). L'ellipticité créée est donc directement proportionnelle à la valeur du champ $\vec{Ee}$ .

Lorsque le faisceau incident 17 se propage suivant la direction (001), ou z, et est polarisé parallèlement à la direction (100), ou x, le faisceau 20 émergeant du cristal sonde 14 ressort avec une polarisation elliptique dans le plan xy perpendiculaire à la direction z de propagation puisque les axes XY de l'ellipsoïde des indices 33 sont les bissectrices de l'angle xy. Cette polarisation elliptique est détectée aisément par l'analyseur 30 orienté perpendiculairement aux directions de propagation et de polarisation du faisceau incident 17, c'est-à-dire suivant la direction (010) ou y.

Pour réaliser une détection linéaire selon une direction x ou y, on peut interposer une lame quart-d'onde 34 en sortie de la fibre d'entrée 8, entre la lentille de collimation 12 et le cristal 14, pour polariser circulairement le faisceau incident 17 dans le plan xy.

Lorsque le cristal sonde est soumis à un champ électrique $\overrightarrow{Ee}$ parallèle à la direction (100) ou (010), ce qui correspond à une rotation de 90° par rapport au cas précédent, le faisceau émergeant 20 reste polarisé dans le plan xz, défini par le vecteur d'onde incident et le polariseur, qui est un plan principal du cristal. Ce plan xz étant perpendiculaire au plan yz qui est l'autre plan principal du cristal de l'analyseur, aucun signal n'est détecté.

Ainsi, le capteur de l'invention permet de mesurer non seulement la valeur du champ électrique mais aussi sa direction.

En effet, contrairement à un cristal sonde de forme quelconque l'utilisation d'un cristal de forme sphérique permet de relier d'une façon biunivoque le champ $\overrightarrow{Ei}$ à l'intérieur du cristal 14 de forme sphérique au champ électrique extérieur $\overrightarrow{Ee}$ à mesurer qui préexistait avant l'introduction de la sonde :

$$(1) \qquad \overrightarrow{Ei} \, \frac{3\varepsilon_e}{2\varepsilon_e + \varepsilon_i} \, \overrightarrow{Ee}$$

Dans cette expression (1), $\varepsilon_e$ est la constante diélectrique relative du milieu ambiant, généralement voisine de l'unité (cas de l'air) et $\varepsilon_i$ est la constante diélectrique du cristal sonde. Ainsi, le champ $\overrightarrow{Ei}$ dans le cristal est relié directement par un simple facteur de proportionnalité au champ $\overrightarrow{Ee}$. à mesurer.

La réflexion du faisceau incident 17 sur le méplat 18 est possible car l'indice de réfraction des cristaux électro-optiques minéraux et relativement élevé (2 dans le cas du $Bi_4Ge_3O_{12}$).

De plus la perte d'intensité lumineuse due au facteur de réflexion inférieur à 1 est partiellement compensée par le doublement de l'ellipticité du fait du doublement du trajet optique dans le cristal sonde.

Dans un cristal taillé suivant un ellipsoïde ayant des axes de dimensions a, b, c, suivant les directions trirectangles X, Y, Z, le champ électrique extérieur $\overrightarrow{Ei}$ et l'induction $\overrightarrow{Di}$ régnant dans le cristal sont reliés au champ électrique $\overrightarrow{Ee}$ à mesurer, qui préexistait avant l'introduction du capteur par l'équation (2) :

$$(2) \qquad (1-n^{(l)})\varepsilon_e \overrightarrow{Ei}^{(l)} + n^{(l)} \overrightarrow{Di}^{(l)} = \varepsilon_e \overrightarrow{Ee}^{(l)}$$

avec l=X,Y ou Z et

$$n^{(l)} = \frac{abc}{2} \int_0^\infty \frac{ds}{(s+a_l^2)Ro}$$

avec $a_l$=a, b ou c et où

$$Ro = \sqrt{(s+a^2)(s+b^2)(s+c^2)}$$

$n^{(l)}$ sont les coefficients de dépolarisation, et sont des nombres qui dépendent de la forme de l'ellipsoïde. Comme $\overrightarrow{Di}$ est relié linéairement à $\overrightarrow{Ei}$ par le tenseur diélectrique de l'ellipsoïde (non forcement diagonal suivant les axes de l'ellipsoïde) il résulte de (2) que le champ est constant dans l'ellipsoide. Si de plus les axes de l'ellipsoïde sont parallèles aux axes principaux du tenseur diélectrique, on peut remplacer dans (2) $\overrightarrow{Di}^{(l)}$ par $\varepsilon_i^{(l)}\overrightarrow{Ei}^{(l)}$, ce qui permet d'expliciter le champ à l'intérieur de l'ellipsoïde selon la relation (3) suivante. :

$$(3) \qquad \overrightarrow{Ei} = \frac{\varepsilon_o \overrightarrow{Ee}^{(l)}}{\varepsilon_o + (\varepsilon_i^{(l)} - \varepsilon_o)n^{(l)}}$$

expression qui se réduit à (1) dans le cas d'une sphère parce que $n^{(l)}$=1/3.

Le schéma de principe de la figure 1 montrait une seule voie optique de mesure.

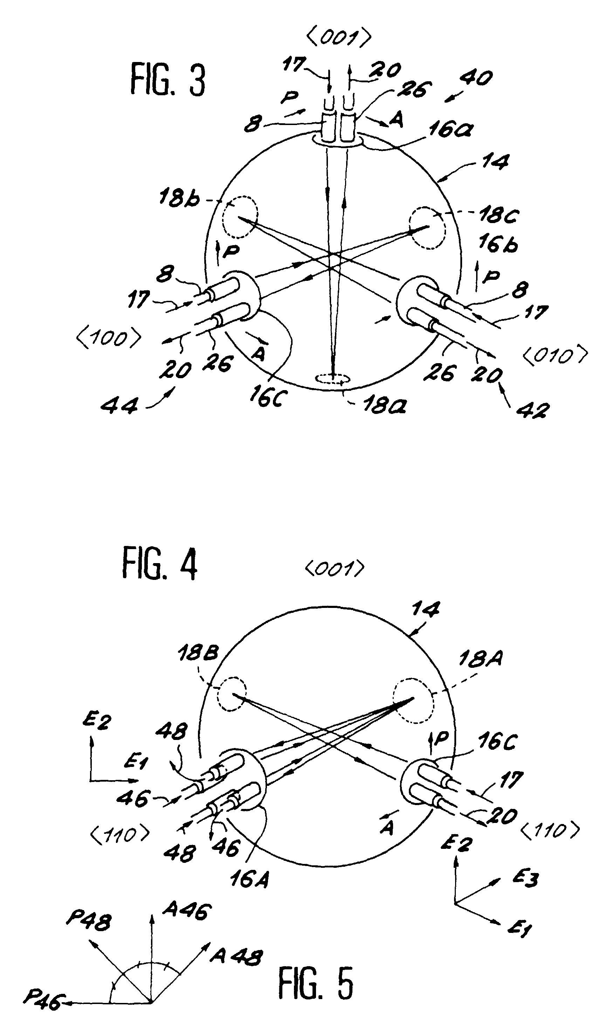

Sur la figure 3, on a représenté un exemple de réalisation du capteur de l'invention comportant trois voies optiques au niveau du cristal sonde 14 respectivement 40, 42 et 44. Chaque voie de mesure n'est sensible qu'à la composante du champ électrique parallèle à la propagation du faisceau lumineux incident 17 (ou émergeant du capteur 20).

En particulier la voie de mesure 40 est sensible à la composante (001) du champ électrique, la voie de mesure 42 est sensible à la composante du champ électrique selon la direction (010) et la voie optique 44 est sensible à la composante du champ électrique orientée selon la direction (100).

Dans ce mode de réalisation, le cristal sonde 14 comporte trois couples de méplats respectivement 16a-18a, 16b-18b et 16c-18c, polis optiquement, les méplats 18a, 18b et 18c étant diamétralement opposés aux méplats 16a, 16b et 16c. Les couples de méplats 16a-18a, 16b-18b et 16c-18c sont disposés respectivement aux endroits où les axes cristallographiques (001), (010) et (100) émergent du cristal. Les méplats 16a, 16b et 16c servent à l'entrée et à la sortie des faisceaux incidents et pertubés par le cristal ; les méplats 18a, 18b et 18c assurent la réflexion des faisceaux incidents dans le cristal.

Sur la figure 3, sont indiquées les directions de polarisation P et d'analyse A des faisceaux incidents 17 et sortants 20, correspondant à l'orientation des axes de polarisation des fibres d'entrée et de sortie et donc à celle de la composante du champ électrique à détecter.

Pour la voie de mesure 40, le polariseur est orienté selon la direction (100) et l'analyseur est orienté selon la direction (010) ; pour la voie de mesure 42, le polariseur est orienté selon la direction (001) et l'analyseur selon une direction (100) ; pour la voie de mesure 44 le polariseur est orienté selon la direction (001) et l'analyseur selon une direction (010). En fait, pour une voie de mesure, les directions de polarisation et d'analyse peuvent être permutées.

Sur la figure 4, le capteur représenté ne comporte que deux couples de méplats respectivement 16A-18A et 16B-18B diamétralement opposés, orientés respectivement selon les plans cristallographiques (110) et ($\overline{1}$10) du cristal sonde 14, mais toujours trois voies optiques de mesure respectivement 46, 48 et 50 dont des parties situées dans le cristal sont orientées selon les axes cristallographiques trirectangles du cristal. Ces trois voies 46, 48 et 50 servent à mesurer indépendamment les trois composantes du champ électrique respectivement E1, E2 et E3.

Dans ce mode de réalisation, la direction de propagation ($\overline{1}$10) des faisceaux incidents 17 et émergeant 20 est utilisée pour mesurer les composantes E1 et E2 du champ électrique parallèles aux directions (110) et (001). A cet effet, on utilise deux couples de polariseurs et d'analyseurs P46-A46 et P48-A48 orientés à 45° l'un de l'autre pour les voies de mesure 46 et 48 qui sont parallèles. Autrement dit, les polariseurs P46 et P48 forment entre eux un angle de 45° et les analyseurs A46 et A48 forment entre eux un angle de 45°, les polariseur P46 et analyseur A46 étant croisés à 90° et les polariseur P48 et analyseur A48 étant aussi croisés à 90°. Cette configuration est représentée sur la figure 5, dans le plan du méplat 16 (plan cristallographique ($\overline{1}$10)).

La troisième composante E3 du champ électrique orientée selon la direction ($\overline{1}$10) est mesurée en faisant propager le faisceau incident suivant la direction (110) grâce à la voie de mesure 50.

L'intérêt de ce mode de réalisation est de placer le plus possible de fibres optiques d'un même côté de la sonde de façon à pouvoir effectuer aisément des mesures dans des endroits difficiles d'accès. En particulier, les voies de mesure 46 et 48 sont parallèles.

Dans les modes de réalisation représentés sur les figures 3 et 4, on n'a représenté que la partie sonde du capteur en vue d'une simplification. Pour cette même raison, on a omis la lame quart-d'onde 34 en sortie des fibres d'entrée.

Dans la configuration du capteur décrit ci-dessus, le cristal était placé, pour chaque voie de mesure, entre un analyseur A et un polariseur P croisés à 90° orientés à 45° des axes principaux de l'ellipsoïde des indices 33. Les positions respectives du polariseur P et de l'analyseur A sont représentées sur la figure 2b. On note $\overline{X}$ et $\overline{Y}$ les vecteurs unitaires selon les axes X et Y.

Le polariseur P était orienté suivant une direction ($\overline{X}$-$\overline{Y}$)/$\sqrt{2}$ et l'analyseur A était perpendiculaire au polariseur P et donc oriente suivant la direction ($\overline{X}$+$\overline{Y}$)/$\sqrt{2}$. Entre l'analyseur et le polariseur de chaque voie de mesure, on a intercalé la lame quart d'onde 34 dont les lignes neutres sont à 45° des axes de polarisation du polariseur et de l'analyseur et donc parallèles aux axes de l'ellipsoïde. Ainsi, cette lame induit un déphasage de $\overline{\pi}$/2 entre les composantes parallèles à X et à Y.

On suppose maintenant que l'analyseur A n'est plus orienté perpendiculairement au polariseur P et on note k l'angle entre l'analyseur A et l'axe principal X de l'ellipsoïde des indices 33.

On peut alors calculer l'expression de l'amplitude du faisceau lumineux en différents endroits d'une voie de mesure, en ne faisant figurer ni le facteur de phase commun aux deux composantes du faisceau selon X et Y, ni les coefficients de transmission, communs à ces deux composantes, à la traversée des différents éléments optiques et en particulier du polariseur, de l'analyseur, du cristal sonde et de la lame quart d'onde.

Après le polariseur, le champ électromagnétique Em1 a pour amplitude :

$$Em1 = \frac{Ew}{\sqrt{2}} \ (\overline{X}\text{-}\overline{Y})$$

E représente l'amplitude du champ électromagnétique initiale et w représente sa pulsation.

Sous l'effet du champ électrique extérieur $\vec{E_i}$ à mesurer, le cristal sonde acquiert une biréfringence induite qui crée une avance de phase $\phi$ de la composante du champ électromagnétique parallèle à $\overline{X}$ et un retard de phase $-\phi$ de la composante du champ électromagnétique parallèle à $\overline{Y}$ valant $(\pi/\lambda)r.no^3.\vec{E_i}$.

Après la traversée du cristal, l'amplitude du champ électromagnétique Em2 vaut donc :

$$Em2 = \frac{Ew}{\sqrt{2}} (e^{i\phi}\overline{X} - e^{-i\phi}\overline{Y})$$

Après la traversée de la lame quart d'onde, la composante parallèle à $\overline{X}$ se déphase de $\overline{\pi}/2$ par rapport à celle parallèle à $\overline{Y}$ et l'amplitude du champ Em3 vaut alors :

$$Em3 = \frac{Ew}{\sqrt{2}} (e^{i(\phi + \overline{\pi}/2)}\overline{X} - e^{-i\phi}\overline{Y}) \tag{4}$$

Dans l'expression (4) précédente, on remarque que $\overline{\pi}/2$ commute avec $\phi$ autrement dit, la lame quart d'onde peut être positionnée indifféremment avant ou après le cristal sonde, ou même être scindée en deux lames huitième d'onde, l'une étant mise avant le cristal et l'autre après.

L'amplitude du champ électromagnétique Em4 après l'analyseur est égale au produit scalaire P.Em3, où P représente le vecteur polarisation, soit :

$$Em4 = \frac{Ew}{\sqrt{2}} \left[ (e^{i(\phi+\pi/2)} \cos k)\ \overline{X} - (e^{-i\phi} \sin k)\overline{Y} \right]$$

Le carré de son module $|Em4|^2$ est proportionnel à l'intensité transmise après le polariseur notée It, $|Ew|^2$ étant proportionnel à l'intensité incidente Ii, avec le même coefficient de proportionnalité. On en déduit :

$$It = \frac{Ii}{2} (1 + \sin 2k \sin\phi) \tag{5}$$

Cette dernière expression (5) montre qu'en module, la variation relative d'intensité transmise avec $\phi$, c'est-à-dire avec le champ électrique $\vec{Ee}$ à mesurer, est maximale pour $k=(\overline{\pi}/4)=m(\overline{\pi}/2)$, où m est un entier, ces angles correspondent à une orientation de l'analyseur parallèle ou perpendiculaire au polariseur, $\sin 2k$ prenant la valeur 1 ou -1 suivant le cas.

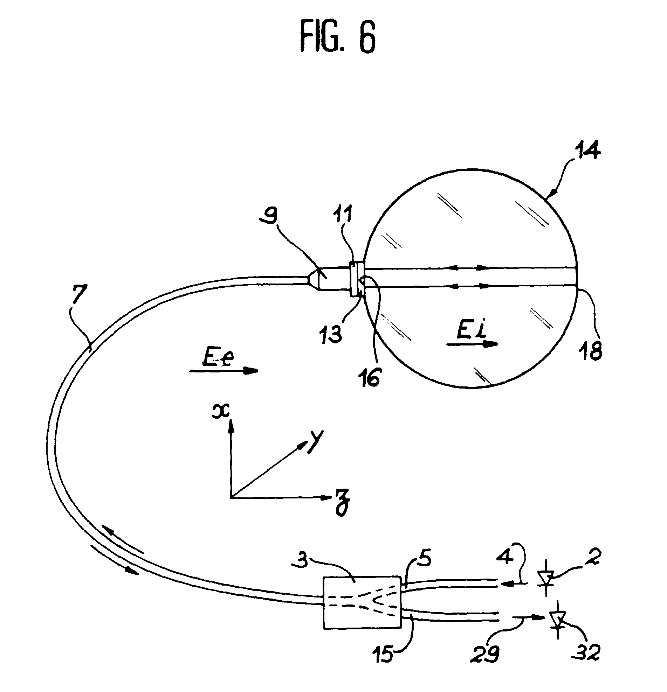

Dans le mode de réalisation du capteur selon l'invention représenté sur la figure 6, les axes de polarisation et d'analyse pour chaque voie de mesure sont parallèles, ce qui correspond à $\sin 2k=-1$ dans l'équation (5).

Sur cette figure 6, on n'a représenté qu'une seule voie de mesure du capteur, destinée à ne mesurer qu'une seule composante d'un champ électrique $\vec{Ee}$. Les deux autres voies de mesure du capteur sont identiques à celle représentée. En outre, le capteur est représenté fonctionnant en réflexion.

Chaque voie de mesure comporte une source lumineuse 2 constituée par une diode laser, monomode ou multimode, émettant un faisceau lumineux monochromatique 4 destiné à être véhiculé par une fibre optique multimode 7 en silice du type 50μm de diamètre de coeur et 125μm de diamètre externe. Cette fibre optique 7 est équipée, à une première extrémité, d'un coupleur bidirectionnel 3 comportant un embranchement 5 placé en vis-à-vis de la diode laser 2 de façon à récupérer le faisceau incident 4.

Conformément à l'invention, la fibre optique multimode sert aussi au transport du faisceau lumineux sortant du cristal sonde 14 qui est un ellipsoïde d'axes xyz ou plus particulièrement une sphère de $Bi_4Ge_3O_{12}$.

A cet effet, le coupleur bidirectionnel 3 comporte un embranchement 15 placé en vis-à-vis du détecteur 32 du type photodiode, servant à diriger le faisceau de mesure analyse 29 sur le détecteur 32.

L'extrémité de la fibre optique 7 opposée à celle équipée du coupleur bidirectionnel 3 est équipée d'une lentille 9 du type lentille Selfoc de "Pitch" (ou "pas fractionnel") 0,25 servant alternativement pour collimater le faisceau incident 4 avant son entrée dans le cristal sonde 14, via le premier méplat 16 du cristal, puis à focaliser le faisceau lumineux sortant du cristal sonde 14, toujours via le méplat 16, dans la fibre optique multimode 7.

Conformément à l'invention, la polarisation du faisceau incident et l'analyse du faisceau sortant du cristal sonde 14 sont assurées par un même élément 11 constitué par un film polarisant collé sur la face de la lentille 9 opposée à celle montée en bout de fibre. Ce film polarisant 11 est par exemple une feuille du type polaroïd d'environ 0,5 mm d'épaisseur.

La linéarisation du signal de sortie est obtenue grâce à une seule lame 13 un huitième d'onde intercalée entre le film polarisant 11 et la sphère sonde 14. Cette lame 13 peut être maintenue en regard du méplat 16 par collage à sa périphérie sur le méplat.

Conformément à l'invention, le faisceau incident 4 véhiculé par la fibre optique 7 est tout d'abord collimaté par la lentille 9 et polarisé par le film polarisant 11 selon la direction x ou y perpendiculaire à la direction z de propagation du cristal de champ électrique $\overrightarrow{Ee}$ à mesurer.

Après un premier passage à travers la lame 13 un huitième d'onde, le faisceau collimaté et polarisé pénètre dans le cristal sonde 14 via le méplat 16 pour être réfléchi sur le méplat 18, diamétralement opposé, puis ressortir par le méplat 16. Le faisceau sortant du cristal 14 traverse à son tour la lame 13, puis l'élément polarisant 11, servant alors d'analyseur, pour être focalisé par la lentille 9 dans la fibre optique 7 et être dirigé par le coupleur 3 sur la photodiode 32 pour être détecté.

Le capteur représenté sur la figure 6 peut être un capteur à trois couples de méplats, ou bien un capteur à deux couples de méplats comme décrit ci-dessus.

Il convient de remarquer que le parallélisme de la direction de polarisation du faisceau incident et de la direction d'analyse du faisceau sortant du cristal, pour une voie optique de mesure de champ électrique par effet Pockels, n'est pas limité à un cristal taillé sous forme d'un ellipsoïde et en particulier d'une sphère. Cette caractéristique s'applique à tout cristal présentant deux faces opposées parallèles, aux points d'entrée et de sortie du faisceau lumineux, en particulier deux faces planes. Cette caractéristique prend tout son intérêt lorsque l'on met en oeuvre une disposition originale, à savoir le fonctionnement en réflexion, puisqu'elle permet d'utiliser une seule et même fibre pour guider le faisceau incident et le faisceau sortant.

**Revendications**

1. Capteur de champ électrique à effet Pockels comportant comme élément sensible un cristal (14) à propriétés électro-optiques, traversé par un faisceau lumineux (17, 20) de directions de propagation et de polarisation déterminées, caractérisé en ce que le cristal est taillé sous forme d'un ellipsoïde et présente une symétrie cristallographique soit uniaxiale 622, 422 ou $\overline{4}$2m, soit cubique $\overline{4}$3m ou 23, les trois axes perpendiculaires de l'ellipsoïde étant orientés selon trois axes cristallographiques trirectangles de symétrie la plus élevée du cristal, le cristal possédant en outre au moins un couple de méplats diamétralement opposés et parallèles et disposés à l'endroit où l'un des axes cristallographiques trirectangles émerge du cristal.

2. Capteur selon la revendication 1, caractérisé en ce que le cristal est taillé sous forme d'une sphère.

3. Capteur selon l'une quelconque des revendications 1 ou 2, caractérisé en ce qu'il comprend au moins une voie de mesure comportant une source de lumière monochromatique (2) émettant un faisceau incident (4), un moyen de polarisation (6) du faisceau incident selon une première direction cristallographique du cristal (14), des moyens d'introduction (9, 12) du faisceau incident polarisé (17) dans le cristal selon une seconde direction cristallographique, un moyen d'analyse (30) du faisceau lumineux (20) sortant du cristal et un élément de détection (32) du signal lumineux analysé.

4. Capteur selon l'une quelconque des revendications 1 à 3, caractérisé en ce qu'il comprend trois voies optiques (40-42-44 ; 46-48-50) de mesure pour mesurer indépendamment les trois composantes perpendiculaires du champ électrique, les parties de ces voies de mesure situées dans le cristal étant orientées selon les trois axes cristallographiques trirectangles de symétrie la plus élevée du cristal.

5. Capteur selon l'une quelconque des revendications 1 à 4, caractérisé en ce que le cristal comporte au moins deux couples de méplats (16a-18a, 16b-18b, 16c-18c, 16A-18A, 16B-18B) parallèles, diamétralement opposés deux à deux, aux endroits où les axes cristallographiques émergent du cristal.

6. Capteur selon l'une quelconque des revendications 1 à 5, caractérisé en ce que le cristal est de symétrie $\overline{4}$3 m, et en particulier du $Bi_4Ge_3O_{12}$.

7. Capteur selon La revendication 6, caractérisé en ce que le moyen de polarisation (6) de chaque voie de mesure est placé directement en sortie de la source lumineuse (2), en ce que le moyen d'analyse (30) est placé directement à l'entrée de l'élément de détection (32) et en ce que chaque voie de mesure comprend en outre une fibre optique d'entrée (8) à maintien de polarisation pour le transport du faisceau incident et une fibre optique de sortie (26) à maintien de polarisation pour le transport du faisceau sortant du cristal.

**8.** Capteur selon la revendication 7, caractérisé en ce que chaque voie de mesure comprend de plus une première lentille de focalisation (10) disposée à la sortie du moyen de polarisation (6) pour focaliser le faisceau incident dans la fibre d'entrée (8), une première lentille de collimation (12) disposée à la sortie de la fibre d'entrée (8) pour collimater le faisceau incident (17) entrant dans le cristal, une seconde lentille de focalisation (24) placée à la sortie du cristal pour focaliser le faisceau (20) sortant du cristal dans la fibre de sortie (26à et une seconde lentille de collimation placée à la sortie de la fibre de sortie (26) pour collimater le faisceau sortant du cristal sur le moyen d'analyse (30).

**9.** Capteur selon la revendication 8, caractérisé en ce que la première lentille de collimation (12) et la seconde lentille de focalisation (24) sont disposées du même côté du cristal (14).

**10.** Capteur selon l'une quelconque des revendications 3 à 9, caractérisé en ce que pour chaque voie de mesure, le faisceau incident (17) entrant dans le cristal et le faisceau (20) sortant du cristal forment un angle de 5° au plus.

**11.** Capteur selon la revendication 10, caractérisé en ce que les fibres optiques d'entrée et de sortie de deux voies de mesure (46, 48) sont disposées d'un même côté du cristal.

**12.** Capteur selon l'une quelconque des revendications 1 à 11, caractérisé en ce qu'il est agencé pour fonctionner en réflexion.

**13.** Capteur selon l'une quelconque des revendications 3 à 6, caractérisé en ce que la direction de polarisation du faisceau incident (4) et la direction d'analyse du faisceau sortant du cristal (14) pour chaque voie de mesure, sont parallèles.

**14.** Capteur selon la revendication 13, caractérisé en ce que le cristal fonctionnant en réflexion, les moyens de polarisation du faisceau incident et les moyens d'analyse du faisceau sortant du cristal (14) consistent en un même élément (11) disposé à l'entrée du cristal et en ce que chaque voie de mesure comprend une fibre optique (7) assurant alternativement le transport du faisceau incident (4) et le transport du faisceau sortant du cristal (14).

**15.** Capteur selon la revendication 14, caractérisé en ce que chaque fibre optique (7) comporte un coupleur optique bidirectionnel (3) à L'une de ses extrémités comportant un premier embranchement (5) destiné à recevoir le faisceau incident (4) émis par la source (2) et un second embranchement (15) destiné à diriger le faisceau sortant du cristal sur le détecteur (32).

**16.** Capteur selon la revendication 14 ou 15, caractérisé en ce que chaque voie de mesure comporte en outre une lentille (9) disposée en regard de l'élément (11) de polarisation et d'analyse assurant alternativement la collimation du faisceau incident sur le cristal (14) et la focalisation du faisceau de mesure sortant du cristal dans la fibre optique (7).

**17.** Capteur selon l'une quelconque des revendications 14 à 16, caractérisé en ce que chaque voie de mesure comporte en outre une lame huitième d'onde (13) disposée en regard de l'élément de polarisation et d'analyse (11).

**18.** Capteur selon la revendication 17, caractérisé en ce que la lame huitième d'onde (13) est intercalée entre l'élément de polarisation et d'analyse (11) et le cristal (14).

**19.** Capteur selon l'une quelconque des revendications 14 à 18, caractérisé en ce que l'élément de polarisation et d'analyse (11) est constitué d'un film mince du type polaroïd.

**Patentansprüche**

**1.** Pockelseffekt-Meßsonde, als empfindliches Element einen Kristall (14) mit elektrooptischen Eigenschaften umfassend, durchquert von einem Lichtbündel (17, 20) von bestimmter Ausbreitungs- und Polarisationsrichtung,

**dadurch gekennzeichnet,**
daß der Kristall in Form eines Ellipsoids geschliffen ist und eine kristallographische Symmetrie aufweist, entweder einachsig 622, 422 oder $\bar{4}$2m, oder kubisch $\bar{4}$3m oder 23, wobei die drei senkrechten Achsen des Ellipsoids entsprechend den drei, drei rechte Winkel bildenden (trirectangles), kristallographischen Achsen der größten Symmetrie des Kristalls orientiert sind und der Kristall wenigstens ein Paar diametral entgegengesetzter und paralleler Flächen bzw. Anflachungen aufweist, angeordnet an der Stelle, wo eine der, drei rechte Winkel bildenden, kristallographischen Achsen aus dem Kristall austritt.

2. Sonde nach Anspruch 1, dadurch gekennzeichnet, daß der Kristall kugelförmig geschliffen ist.

3. Sonde nach einem der Ansprüche 1 oder 2, dadurch gekennzeichnet, daß sie wenigstens eine Meßstrecke enthält, umfassend eine ein eintreffendes Bündel (4) ausstrahlende monochromatische Lichtquelle (2), eine Einrichtung (6) zum Polarisieren des einfallenden Bündels entsprechend einer ersten kristallographischen Richtung des Kristalls (14), Einleiteinrichtungen (9, 12) des polarisierten eintreffenden Bündels (17) in den Kristall entsprechend einer zweiten kristallographischen Richtung, eine Analyseeinrichtung (30) des aus dem Kristall austretenden Lichtbündels (20) und ein Detektionselement (32) des analysierten Lichtsignals.

4. Sonde nach einem der Ansprüche 1 bis 3, dadurch gekennzeichnet, daß drei optische Meßstrecken (40-42-44; 46-48-50) umfaßt, um die drei senkrechten Komponenten des elektrischen Feldes unabhängig zu messen, wobei die in dem Kristall befindlichen Teile dieser Meßstrecken entsprechend den drei, drei rechte Winkel bildenden, kristallographischen Achsen der größten Symmetrie des Kristalls orientiert sind.

5. Sonde nach einem der Ansprüche 1 bis 4, dadurch gekennzeichnet, daß der Kristall wenigstens zwei Paare von parallelen, paarweise diametral entgegengesetzten Flächen bzw. Anflachungen (16a-18a, 16b-18b, 16c-18c, 16A-18A, 16B-18B) an den Stellen aufweist, wo die kristallographischen Achsen aus dem Kristall austreten.

6. Sonde nach einem der Ansprüche 1 bis 5, dadurch gekennzeichnet, daß es ein Kristall der Symmetrie 43 m ist, insbesondere aus $Bi_4Ge_3O_{12}$.

7. Sonde nach Anspruch 6, dadurch gekennzeichnet, daß die Polarisationseinrichtung (6) jeder Meßstrecke sich direkt am Ausgang der Lichtquelle (2) befindet, und dadurch, daß die Analyseeinrichtung (30) sich direkt am Eingang des Detektionselements (32) befindet, und dadurch, daß jede Meßstrecke außerdem eine optische Eingangsfaser (8) mit Polarisationsaufrechterhaltung für die Übertragung des eintreffenden Bündels umfaßt und eine optische Ausgangsfaser (26) mit Polarisationsaufrechterhaltung für die Übertragung des aus dem Kristall austretenden Bündels.

8. Sonde nach Anspruch 7, dadurch gekennzeichnet, daß jede Meßstrecke außerdem umfaßt: eine erste Fokussierlinse (10), angeordnet am Ausgang der Polarisationseinrichtung (6), um das eintreffende Bündel in die Eingangsfaser (8) zu fokussieren, eine erste Kollimationslinse (12), angeordnet am Ausgang der Eingangsfaser (8), um das eintreffende, in den Kristall eindringende Bündel (17) zu sammeln, eine zweite Fokussierlinse (24), angeordnet am Ausgang des Kristalls, um das aus dem Kristall austretende Bündel (20) in die Ausgangsfaser (26) zu fokussieren, und eine zweite Kollimationslinse, angeordnet am Ausgang der Ausgangsfaser (26), um das aus dem Kristall austretende Bündel auf die Analyseeinrichtung (30) zu fokussieren.

9. Sonde nach Anspruch 8, dadurch gekennzeichnet, daß die erste Kollimationslinse (12) und die zweite Fokussierlinse (24) auf derselben Seite des Kristalls (14) angeordnet sind.

10. Sonde nach einem der Ansprüche 3 bis 9, dadurch gekennzeichnet, daß bei jeder Meßstrecke der eintreffende, in den Kristall eindringende Strahl (17) und der aus dem Kristall austretende Strahl (20) einen Winkel von höchstens 5° bilden.

11. Sonde nach Anspruch 10, dadurch gekennzeichnet, daß die optischen Eingangs- und Ausgangs fasern von zwei Meßstrecken (46, 48) auf auf ein und derselben Seite des Kristalls angeordnet sind.

12. Sonde nach einem der Ansprüche 1 bis 11, dadurch gekennzeichnet, daß sie eingerichtet bzw. gebaut ist, um mit Reflexion zu arbeiten.

13. Sonde nach einem der Ansprüche 3 bis 6, dadurch gekennzeichnet, daß die polarisationsrichtung des eintreffenden Bündels (4) und die Analyserichtung des aus dem Kristall (14) austretenden Bündels bei jeder Meßstrecke parallel sind.

14. Sonde nach Anspruch 13, dadurch gekennzeichnet, daß, wenn der Kristall mit Reflexion arbeitet, die Polarisationseinrichtungen des eintreffenden Bündels und die Analyseeinrichtungen des aus dem Kristall (14) austretenden Bündels aus demselben Element (11) bestehen, angeordnet am Eingang des Kristalls, und dadurch, daß jede Meßstrecke eine optische Faser (7) umfaßt, die abwechselnd die Übertragung des eintreffenden Bündels (4) und die Übertragung des aus dem Kristall (14) austretenden Bündels sicherstellt.

15. Sonde nach Anspruch 14, dadurch gekennzeichnet, daß jede optische Faser (7) einen bidirektionellen optischen Koppler (3) an einem ihrer Enden aufweist, der einen ersten Zweig (5) zum Empfangen des durch die Quelle (2) ausgestrahlten eintreffenden Bündels (4) umfaßt und einen zweiten Zweig (15), um das aus dem Kristall austretende Bündel auf den Detektor (32) zu richten.

16. Sonde nach einem der Ansprüche 14 oder 15, dadurch gekennzeichnet, daß jede Meßstrecke außerdem eine Linse (9) umfaßt, dem Polarisierungs- und Analyseelement (11) gegenüberstehend, die wechselweise die Kollimation des eintreffenden Bündels auf den Kristall (14) und die Fokussierung des aus dem Kristall (14) austretenden Meßbündels in die optische Faser (7) sicherstellen.

17. Sonde nach einem der Ansprüche 14 bis 16, dadurch gekennzeichnet, daß jede Meßstrecke außerdem ein Achtelwellenlängenplättchen (13) umfaßt, dem Polarisations- und Analyseelement (11) gegenüber angeordnet.

18. Sonde nach Anspruch 17, dadurch gekennzeichnet, daß das Achtelwellenlängenplättchen (13) eingeschaltet ist zwischen das Polarisations- und Analyseelement (11) und den Kristall (14).

19. Sonde nach einem der Ansprüche 14 bis 18, dadurch gekennzeichnet, daß das Polarisations- und Analyseelement (11) durch einen Dünnfilm des Polaroidtyps gebildet wird.

## Claims

1. Pockels effect electric field sensor comprising, as a sensitive element, a crystal (14) with electro-optical properties and traversed by a luminous beam (17, 20) with specific polarization and propagation directions, wherein the crystal is cut into the shape of an ellipsoid and has a crystallographic symmetry, either unaxial 622, 422 or 42m or cubic 43m or 23, the three perpendicular axes of the ellipsoid being orientated along the three highest trirectangular crystallographic axes with the strongest symmetry of the crystal, the crystal also having at least one pair of diametrically opposite, parallel flats positioned at the location where one of the trirectangular crystallographic axes emerges from the crystal.

2. Sensor according to claim 1, characterized in that the crystal is cut into the shape of a sphere.

3. Sensor according to claim 1 or 2, characterized in that it includes at least one measuring channel comprising a monochromatic light source (2) emitting an incident beam (4), a device (6) for polarizing the incident beam along a first crystallographic direction of the crystal (14), means (9, 12) for introducing the polarized incident beam (17) into the crystal along a second crystallographic direction, a device (30) for analyzing the luminous beam (20) emerging from the crystal and an element (32) for detecting the analyzed luminous signal.

4. Sensor according to any one of the claims 1 to 3, characterized in that it includes three optical measuring channels (40-42-44; 46-48-50) to independently measure the three perpendicular components of the electric field, the sections of these measuring channels situated in the crystal being orientated along the three trirectangular crystallographic axes with the strongest symmetry of the crystal.

5. Sensor according to any one of the claims 1 to 4, characterized in that the crystal comprises at least two pairs of flat parts (16a-18a, 16b-18b, 16c-18c, 18A-18A, 16B-18B) diametrically opposing each other parallel to the locations where the crystallographic axes emerge from the crystal.

6. Sensor according to any one of the claims 1 to 5, characterized in that the crystal has a symmetry of 43m and in particular is a $Bi_4Ge_3O_{12}$ crystal.

**7.** Sensor according to claim 6, characterized in that the device (6) for polarizing each measuring channel is placed directly at the outlet of the luminous source (2), that the analysis device (30) is placed directly at the inlet of the detection element (32) and that each measuring channel further includes a polarization retention inlet optical fibre (8) for carrying the incident beam and a polarization retention outlet optical fibre (26) for carrying the beam emerging from the crystal.

**8.** Sensor according to claim 7, characterized in that each measuring channel further includes a first focussing lens (10) disposed at the outlet of the polarization device (6) so as to focus the incident beam in the inlet fibre (8), a first collimation lens (12) disposed at the outlet of the inlet fibre (8) so as to collimate the incident beam (17) entering into the crystal, a second focussing lens (24) placed at the outlet of the crystal so as to focus the beam (20) emerging from the crystal in the outlet fibre (26) and a second collimation lens placed at the outlet of the outlet fibre (26) so as to collimate the beam emerging from the crystal on the analysis device (30).

**9.** Sensor according to claim 8, characterized in that the first collimation lens (12) and the second focussing lens (24) are disposed on the same side of the crystal (14).

**10.** Sensor according to any one of the claims 3 to 9, characterized in that for each measuring channel, the incident beam (17) entering into the crystal and the beam (20) emerging from the crystal form an angle of at the most 5°.

**11.** Sensor according to claim 10, characterized in that the optical inlet and outlet fibres of two measuring channels (46, 48) are disposed on the same side of the crystal.

**12.** Sensor according to any one of the claims 1 to 11, characterized in that the sensor is disposed to function on reflection.

**13.** Sensor according to any one of the claims 3 to 6, characterized in that the polarization direction of the incident beam (4) and the analysis direction of the beam emerging from the crystal (14) for each measuring channel are parallel.

**14.** Sensor according to claim 13, characterized in that the crystal functioning on reflection, the means for polarizing the incident beam and the means for analyzing the beam emerging from the crystal (14) consist of one and the same element (11) disposed at the inlet of the crystal and that each measuring channel includes an optical fibre (7) alternately ensuring carrying of the incident beam (4) and carrying of the beam emerging from the crystal (14).

**15.** Sensor according to claim 14, characterized in that each optical fibre (7) comprises a bidirectional optical coupler (3) at one of its extremities comprising a first branching (5) intended to receive the incident beam (4) emitted by the source (2) and a second branching (15) intended to direct the beam emerging from the crystal onto the detector (32).

**16.** Sensor according to claim 14 or 15, characterized in that each measuring channel further comprises a lens (9) disposed opposite the polarization and analysis element (11) alternately ensuring collimation of the incident beam on the crystal (14) and focussing of the measuring beam emerging from the crystal in the optical fibre (7).

**17.** Sensor according to any one of the claims 14 to 16, characterized in that each measuring channel further comprises an eighth-wave plate (13) disposed opposite the analysis and polarization element (11).

**18.** Sensor according to claim 17, characterized in that the eighth-wave plate (13) is inserted between the analysis and polarization element (11) and the crystal (14).

**19.** Sensor according to any one of the claims 14 to 18, characterized in that the analysis and polarization element (11) is constituted by a thin polaroid type film.

# FIG. 1

# FIG. 2 a

# FIG. 2 b

FIG. 3

FIG. 4

FIG. 5

# FIG. 6